(19) Europäisches Patentamt
European Patent Office
Office européen des brevets

(11) **EP 3 966 843 B1**

(12) **FASCICULE DE BREVET EUROPEEN**

(45) Date de publication et mention
de la délivrance du brevet:
**08.01.2025 Bulletin 2025/02**

(21) Numéro de dépôt: **20737227.7**

(22) Date de dépôt: **22.05.2020**

(51) Classification Internationale des Brevets (IPC):
**H01J 1/34** *(2006.01)*      **H01J 29/08** *(2006.01)*
**H01J 31/50** *(2006.01)*

(52) Classification Coopérative des Brevets (CPC):
**H01J 31/507; H01J 1/34; H01J 29/08;**
H01J 2231/5001

(86) Numéro de dépôt international:
**PCT/FR2020/000176**

(87) Numéro de publication internationale:
**WO 2020/234518 (26.11.2020 Gazette 2020/48)**

(54) **DÉTECTEUR DE RAYONNEMENT ÉLECTROMAGNÉTIQUE AVEC PHOTOCATHODE À RENDEMENT QUANTIQUE AMÉLIORÉ**

DETEKTOR FÜR ELEKTROMAGNETISCHER STRAHLUNG MIT PHOTOKATHODE MIT VERBESSERTER QUANTENAUSBEUTE

DETECTOR FOR ELECTROMAGNETIC RADIATION COMPRISING A PHOTOCATHODE WITH IMPROVED QUANTUM YIELD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.05.2019 FR 1905412**

(43) Date de publication de la demande:
**16.03.2022 Bulletin 2022/11**

(73) Titulaire: **Photonis France**
**19100 Brive (FR)**

(72) Inventeurs:
• **LAVOUTE, Pascal**
**19100 BRIVE LA GAILLARDE (FR)**
• **NÜTZEL, Gert**
**2611 RV DELF (NL)**

(74) Mandataire: **Cabinet Laurent & Charras**
**Le Contemporain**
**50 Chemin de la Bruyère**
**69574 Dardilly Cedex (FR)**

(56) Documents cités:
**US-A1- 2007 096 648      US-A1- 2014 239 157**

## Description

### Domaine technique

La présente invention concerne le domaine général des photocathodes telles que celles utilisées dans les tubes intensificateurs d'image ou les tubes photomultiplicateurs.

### Etat de la technique antérieure

Les détecteurs de rayonnement électromagnétique, tels que les tubes intensificateurs d'image ou les tubes photomultiplicateurs, permettent de détecter un rayonnement électromagnétique dans une bande spectrale donnée en le convertissant en un signal de sortie lumineux ou électrique.

Ces détecteurs comportent généralement une photocathode pour recevoir le rayonnement électromagnétique et émettre en réponse un flux de photoélectrons, un dispositif multiplicateur d'électrons pour recevoir ledit flux de photoélectrons et émettre en réponse un flux d'électrons, dits secondaires, et enfin un dispositif de sortie pour recevoir ledit flux d'électrons et le convertir en un signal de sortie.

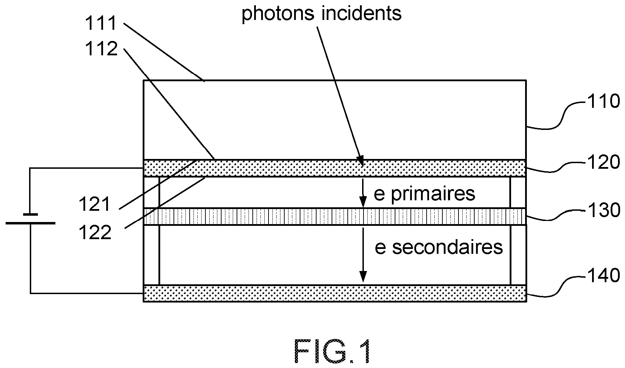

La Fig. 1 représente un détecteur de rayonnement électromagnétique connu de l'état de la technique.

Comme illustré sur la figure, un tel détecteur, 100, comprend une fenêtre d'entrée en matériau transparent, 110, généralement en verre, servant de support à une couche photoémissive ou photocathode, 120, réalisée en un matériau semiconducteur. La fenêtre d'entrée présente une face avant, 111, destinée à recevoir le flux de photons incidents et une face arrière, 112 opposée à la face avant. La couche photoémissive comporte une face amont, 121, en contact avec la face arrière de la fenêtre d'entrée et une face aval 122, à partir de laquelle les photoélectrons sont émis.

La photocathode est portée à un potentiel négatif par rapport à celui appliqué au dispositif multiplicateur d'électrons 130, le dispositif multiplicateur d'électrons étant lui-même à un potentiel négatif par rapport à celui appliqué au dispositif de sortie 140, par exemple un écran phosphore ou une matrice CCD.

Les photons arrivant sur la face avant 111 traversent la fenêtre transparente 110 et pénètrent dans la couche photoémissive 120, où ils génèrent des paires électrons-trous s'ils possèdent une énergie supérieure à la largeur de bande interdite du matériau semiconducteur. Les photoélectrons migrent vers la face aval, 122, de la photocathode où ils sont émis dans le vide, avant d'être multipliés par le dispositif multiplicateur d'électrons, 130, et convertis en un signal lumineux ou électrique par le dispositif de sortie, 140.

Le rendement quantique de la photocathode est classiquement défini comme le rapport entre le nombre de photoélectrons émis par la photocathode et le nombre de photons reçus. Le rendement quantique de la photocathode est un paramètre essentiel du détecteur, il conditionne à la fois sa sensibilité et son rapport signal sur bruit. Il dépend notamment de la longueur d'onde des photons incidents et de l'épaisseur de la couche photoémissive.

Le rendement quantique peut être sensiblement dégradé par la présence de défauts à l'interface entre la photocathode, 120, et la fenêtre transparente, 110. Plus précisément, ces défauts créent des états de surface piégeant les photoélectrons générés dans la photocathode. Les photoélectrons ainsi piégés ne peuvent plus migrer vers la face aval de la photocathode et ne participent donc pas au photocourant généré par les photoélectrons émis par la photocathode.

Cette détérioration du rendement quantique de la photocathode se fait particulièrement sentir dans les faibles longueurs d'onde. En effet, les photons de plus forte énergie interagissent plus tôt avec le semiconducteur le long de leur trajectoire au sein de la photocathode. Les photoélectrons générés par ces photons ont par conséquent une probabilité plus élevée d'être piégés à l'interface.

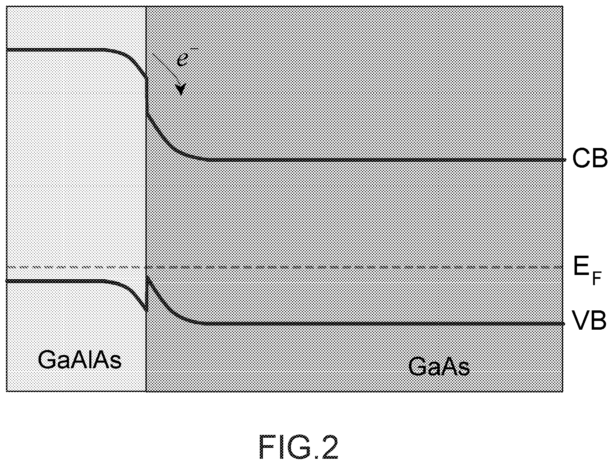

Pour combattre cette détérioration du rendement quantique, il a été proposé d'introduire, à l'interface entre la fenêtre d'entrée et de la photocathode, une couche intermédiaire de matériau semiconducteur possédant une bande interdite plus large que celle de de la photocathode. Ainsi, par exemple, si la photocathode est réalisée dans un matériau semiconducteur III-V tel que GaAs de type p, on peut introduire une couche intermédiaire de GaAlAs de type p à l'interface. La plus grande largeur de bande interdite de GaAlsAs par rapport à GaAs crée une courbure de bandes vers le haut (*upward band bending*) du côté de la photocathode comme on peut le voir dans le diagramme de bandes de la Fig. 2. Ainsi, lorsqu'un photon génère une paire électron-trou à proximité de l'interface, le photoélectron est extrait hors de la zone de recombinaison par le champ électrique local.

Cette solution n'est toutefois pas transposable à tous les types de photocathode, en particulier à celles réalisées dans un matériau polycristallin, par exemple dans un composé bi- ou multi-alcalin tel que $SbK_2Cs$, $SbRb_2Cs$, $SbRb_2Cs$, $SbCs_3$, $SbNa_3$, $SbNaKRbCs$, $SbNaKCs$, $SbNa_2KCs$. Du fait de leur structure polycristalline, ces photocathodes ne possèdent pas un diagramme de bandes bien défini et il est difficile de prévoir une couche intermédiaire en un second matériau semiconducteur permettant d'obtenir la courbure de bandes souhaitée à l'interface avec le matériau polycristallin.

De manière plus générale, même pour des photocathodes réalisées dans un matériau semiconducteur monocristallin, il n'est pas toujours aisé de trouver un second matériau semiconducteur adapté permettant à la fois d'obtenir un accord de maille et la courbure de bandes souhaitée avec le matériau semiconducteur constitutif de la photocathode. Ceci est notamment problématique pour les photocathodes réalisées dans un matériau semiconducteur II-VI, tel que CdTe.

Un but de la présente invention est par conséquent de proposer un détecteur de rayonnement électromagnétique possédant une photocathode en un premier matériau semiconducteur, présentant un rendement quantique élevé sans pour autant nécessiter une couche intermédiaire en un second matériau semiconducteur adapté, entre la fenêtre d'entrée et la photocathode.

Le document US2014/0239157A1 décrit un détecteur de rayonnement électromagnétique comprenant une couche photosensible (PSL) située entre la photocathode (PK) et une couche conductrice. Le rôle de la couche photosensible, polarisée positivement par rapport à la photocathode est de réduire le gain du détecteur en cas de fort rayonnement en devenant électriquement conductrice, les photoélectrons générés à l'interface PSL-PK étant alors évacués par l'électrode reliée à la couche photosensible. Une couche diélectrique peut être située entre la couche photosensible et la photocathode.

## Présentation de l'invention

La présente invention est définie par un détecteur de rayonnement électromagnétique comprenant une fenêtre d'entrée en verre possédant une face amont destinée à recevoir un flux de photons incidents ainsi qu'une face aval opposée à la face amont, une photocathode sous la forme d'une couche semiconductrice, destinée à générer des photoélectrons à partir des photons incidents et à émettre lesdits photoélectrons ainsi générés, un dispositif multiplicateur d'électrons configuré pour recevoir les photoélectrons émis par la photocathode et à générer pour chaque photoélectron reçu une pluralité d'électrons secondaires et un dispositif de sortie configuré pour générer un signal de sortie à partir desdits électrons secondaires, le détecteur de rayonnement étant spécifique en ce qu'une couche conductrice transparente est déposée sur la face aval de la fenêtre d'entrée et qu'une couche mince isolante est disposée entre ladite couche conductrice et la couche semiconductrice, la couche conductrice étant reliée électriquement à une première électrode et la couche semiconductrice étant reliée électriquement à une seconde électrode, la première électrode étant destinée à être portée à un potentiel inférieur à celui appliqué à la second électrode.

La couche semiconductrice peut notamment être réalisée dans un matériau semiconducteur polycristallin. Ce matériau peut être choisi parmi $SbK_2Cs$, $SbRb_2Cs$, $SbRb_2Cs$, $SbCs_3$, $SbNa_3$, $SbNaKRbCs$, $SbNaKCs$, $SbNa_2KCs$.

Alternativement, la couche semiconductrice peut être réalisée dans un matériau semiconducteur monocristallin III-IV ou II-VI.

La couche conductrice transparente est typiquement réalisée en ITO ou ZnO.

La couche mince isolante est avantageusement réalisée dans un matériau diélectrique présentant une tension de claquage supérieure à 1 V/ 10 nm. Cette couche mince isolante a généralement une épaisseur de 100 à 200 nm. Le matériau diélectrique est avantageusement choisi parmi $Al_2O_3$, $SiO_2$, $HfO_3$.

La différence de potentiel appliquée entre la seconde électrode et la première électrode est choisie supérieure ou

$$\frac{4\delta\sqrt{\varepsilon_s \Delta U_{bb} e N_a}}{\varepsilon_d}$$

égale à où $\varepsilon_s$ et $\varepsilon_d$ sont respectivement les constantes diélectriques de la couche semiconductrice et de la couche isolante, $\delta$ est l'épaisseur de la couche isolante, $\Delta U_{bb}$ est l'amplitude de la courbure de bande en absence de différence de potentiel appliquée, $N_a$ est la concentration d'accepteurs dans la couche semiconductrice et $e$ est la charge de l'électron.

## Brève description des figures

D'autres caractéristiques et avantages de l'invention apparaîtront à la lecture d'un mode de réalisation préférentiel de l'invention, décrit en référence aux figures jointes parmi lesquelles :

La Fig. 1, déjà décrite représente schématiquement la structure d'un détecteur de rayonnement électromagnétique connu de l'état de la technique ;
La Fig. 2 représente le diagramme de bandes d'une photocathode à rendement quantique élevé, connue de l'état de la technique ;
La Fig. 3 représente schématiquement la structure d'un détecteur de rayonnement électromagnétique selon un mode de réalisation de l'invention ;
La Fig. 4 représente le diagramme de bandes d'une photocathode utilisée dans le détecteur de rayonnement électromagnétique de la Fig. 3.

**Description des modes de réalisation**

L'idée à la base de l'invention est d'introduire entre la fenêtre d'entrée du détecteur électromagnétique et la photocathode, une structure capacitive formée d'une couche conductrice mince servant d'électrode de polarisation, et d'une couche mince de diélectrique. L'électrode de polarisation est destinée à être polarisée à un potentiel inférieur à celui appliqué à la photocathode de manière à chasser hors de la zone de recombinaison les photoélectrons générés à proximité de l'interface.

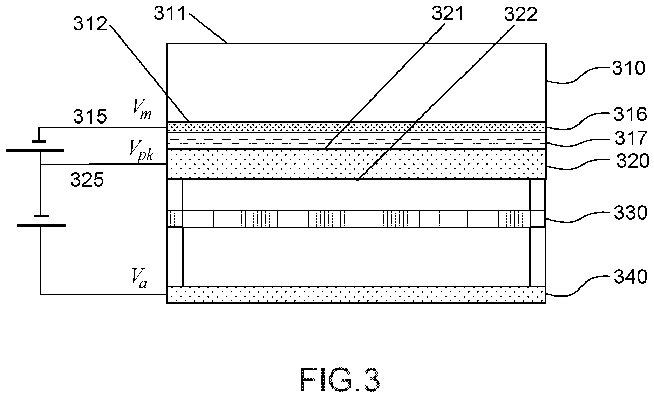

La Fig. 3 représente de manière schématique la structure d'un détecteur de rayonnement électromagnétique selon un mode de réalisation de l'invention.

Le détecteur comprend comme précédemment une fenêtre d'entrée, 310, en un matériau transparent dans la bande spectrale d'intérêt, par exemple une fenêtre en quartz ou en verre borosilicate.

La fenêtre d'entrée présente une face amont, 311, destinée à recevoir le flux de photons incidents et une face aval, 312, opposée à la face amont.

Une couche conductrice, 316, transparente dans la bande spectrale d'intérêt, est déposée sur la face aval de la fenêtre d'entrée. Elle est en outre reliée électriquement à une première électrode 315. La couche conductrice transparente peut être avantageusement réalisée en ZnO ou en ITO. Son épaisseur est choisie dans la gamme 50 à quelques centaines de nm et avantageusement égale à 150 nm.

Une couche isolante, 317, réalisée en un matériau diélectrique, est disposée entre la couche conductrice 316 et la couche semiconductrice de la photocathode, 320. Le matériau diélectrique est choisi pour présenter une tension de claquage élevée, par exemple supérieure à 1V/ 10 nm. L'épaisseur de la couche diélectrique est typiquement de 100 à 200 nm. Le matériau diélectrique pourra notamment être de l'alumine ($Al_2O_3$), de la silice ($SiO_2$), ou un oxyde d'Hafnium ($HFO_3$). Selon une variante, la couche isolante pourra être réalisée sous la forme d'une structure diélectrique multicouche faisant intervenir les matériaux diélectriques précités.

La photocathode 320 est réalisée sous la forme d'une couche semiconductrice déposée sur la couche isolante 317. Le semiconducteur peut être monocristallin, par exemple un semiconducteur III-V, tel que GaAs ou II-VI, tel que CdTe. Alternativement, il peut avoir une structure polycristalline, comme ce peut être notamment le cas pour les composés bi- ou multi-alcalins tels que $SbK_2Cs$, $SbRb_2Cs$, $SbRb_2Cs$, $SbCs_3$, $SbNa_3$, SbNaKRbCs, SbNaKCs, $SbNa_2KCs$.

Dans tous les cas, la photocathode est reliée électriquement à une seconde électrode, 325.

Les électrons primaires émis par la photocathode sont émis dans le vide et multipliés par un dispositif de multiplication d'électrons, 330, par exemple une galette de microcanaux (GMC) ou une couche de diamant nanocristallin comme décrit dans la demande publiée FR-A-2961628 déposée au nom de la présente Demanderesse, voire encore un multiplicateur à dynodes discrètes dans le cas des photomultiplicateurs classiques.

Le dispositif de multiplication d'électrons est relié à une troisième électrode (non représentée).

Les photoélectrons ainsi multipliés, dénommés électrons secondaires, sont reçus par le dispositif de sortie, 340. Le dispositif de sortie peut comporter un écran phosphore, assurant une conversion directe en image comme dans un intensificateur d'image ou bien une matrice CCD ou CMOS pour fournir un signal électrique représentatif de la distribution du flux de photons incidents, comme dans un système EB-CCD *(Electron Bombarded CCD)* ou EBCMOS *(Electron Bombarded CMOS),* ou une simple anode métallique dans le cas des photomultiplicateurs classiques.

Le dispositif de sortie est relié à une quatrième électrode jouant le rôle d'anode.

La fenêtre d'entrée 310, la photocathode 320, le dispositif de multiplication d'électrons, 330 et le dispositif de sortie sont avantageusement montés dans un corps de tube compact, les connexions électriques des électrodes avec l'alimentation extérieures étant assurées par des bagues de connexion séparées par des entretoises diélectriques. Selon une variante avantageuse de réalisation, le corps de tube pourra se présenter sous la forme d'un substrat céramique multicouche sur lequel sera fixé le dispositif de multiplication d'électrons comme décrit dans la demande publiée FR-A-2925218 déposée au nom de la présente Demanderesse.

Bien entendu, comme dans une photocathode conventionnelle, l'extraction des photoélectrons et leur accélération sont assurées en appliquant une haute tension entre l'anode et la cathode. Toutefois, de manière originale, il est appliqué une tension négative entre la première électrode et la seconde électrode de sorte que la couche conductrice est portée à un potentiel inférieur à celui de la photocathode. Plus précisément, si l'on note respectivement $V_m$, $V_{pk}$, $V_a$ les potentiels respectifs de la couche conductrice, de la photocathode et l'anode, on a $V_m < V_{pk} \ll V_a$. En d'autres termes, la différence de potentiel entre la couche conductrice et l'anode est essentiellement due à celle entre la photocathode et l'anode. En pratique, la différence de potentiel $V_{pk}$-$V_m$ sera comprise entre 1 et 50 V alors que la différence de potentiel $V_a$-$V_{pk}$ est de l'ordre de plusieurs centaines de V.

L'application de cette tension sur la première électrode a pour effet de chasser les photoélectrons générés dans la zone de recombinaison 321 vers la surface d'émission 322 de la photocathode. La zone de recombinaison de la photocathode est située à l'interface avec la couche diélectrique. L'homme du métier comprendra en effet que les dislocations et défauts à l'interface avec la couche diélectrique jouent le rôle de centre de recombinaison des photoélectrons. Le temps de séjour des photoélectrons dans la zone de recombinaison est très court du fait du champ électrique appliqué entre la couche conductrice et la photocathode et réduit d'autant leur probabilité de recombinaison.

En outre, le transport des photoélectrons au sein de la photocathode n'est plus dû principalement à la diffusion mais également au champ électrique interne. Il en résulte une réduction du temps moyen de parcours des électrons dans la photocathode et une amélioration du temps de réponse du photodétecteur.

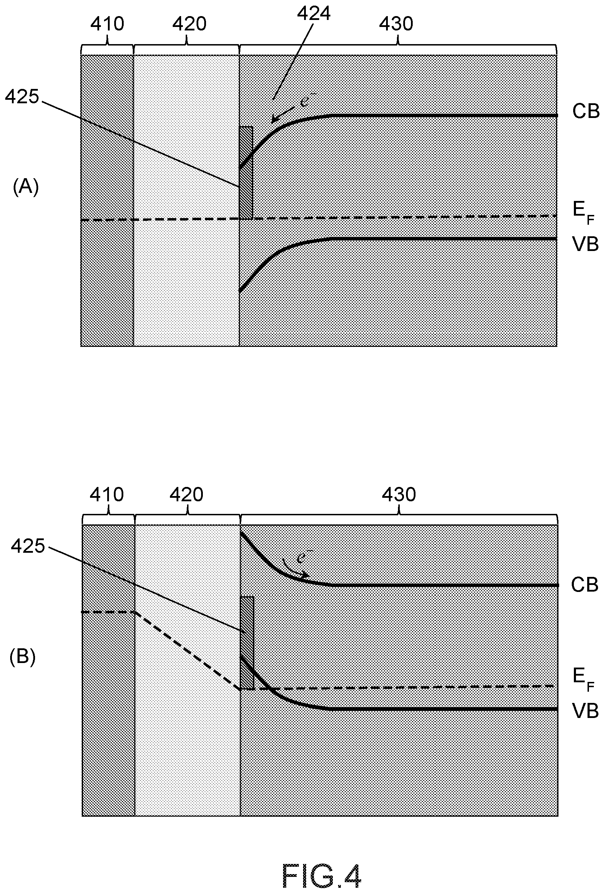

La Fig. 4 représente le diagramme de bandes d'une photocathode utilisée dans le détecteur de rayonnement électromagnétique de la Fig. 3.

On a indiqué par 410 la couche conductrice, par 420 la couche isolante et par 430 la couche semiconductrice de la photocathode.

La partie haute de la figure, désignée par (A), correspond à la situation où aucune différence de potentiel n'est appliquée entre la couche conductrice et la couche semiconductrice (de type p).

On remarque que les bandes de conduction et de valence de la couche semiconductrice sont incurvées vers le bas à l'interface avec la couche isolante. Autrement dit, dans une telle situation, un gaz de photoélectrons se forme à l'interface, dans la cuvette de potentiel 424. On a désigné par ailleurs par 425 la zone de recombinaison où se trouvent les états de surface.

Les photoélectrons générés à ou près de l'interface ont une probabilité de recombinaison élevée avec les états de surface, ce d'autant qu'un photoélectron présent dans la cuvette de potentiel aura tendance à migrer vers la zone de recombinaison.

La partie basse de la figure, désignée par (B), correspond à la situation où la couche conductrice est portée à un potentiel inférieur à celui de la couche semiconductrice. Plus précisément, la différence de potentiel $V_{pk} - V_m$ est choisie ici supérieure à une valeur de seuil $\Delta V_{th}$ comme explicité plus loin.

On remarque que les bandes de conduction et de valence de la couche semiconductrice sont cette fois-ci incurvées vers le haut à l'interface avec la couche isolante. Autrement dit, dans une telle situation, les photoélectrons générés à l'interface sont chassés de la zone de recombinaison 425 par le champ électrique présent dans la zone de courbure des bandes.

La différence de potentiel $V_{pk} - V_m$ à appliquer peut être estimée comme suit : en l'absence de tension appliquée (situation (A)), la charge d'espace (négative) correspondant à la courbure de bandes équilibre la charge (positive) des états de surface. Cette charge d'espace peut être approximée par :

$$Q_b \simeq -e N_a x_{dt} \qquad (1)$$

où e est la charge de l'électron, $N_a$ est la concentration d'accepteurs dans la photocathode (de type p) et $x_{dt}$ est la largeur de la zone de déplétion.

La largeur de la zone de déplétion peut être estimée par :

$$x_d \simeq \sqrt{\frac{4\varepsilon_s \Delta U_{bb}}{e N_a}} \qquad (2)$$

où $\varepsilon_s$ est la constante diélectrique du semiconducteur et $\Delta U_{bb}$ est la courbure de bande en absence de différence de potentiel. Il en résulte que $Q_b \simeq -\sqrt{4\varepsilon_s \Delta U_{bb} e N_a}$.

La différence de potentiel à appliquer entre la couche conductrice et la photocathode permettant de simplement équilibrer cette charge par effet capacitif dans la photocathode est donc de :

$$\left(V_m - V_{pk}\right)^{FF} = -\frac{Q_b}{C} = -\frac{Q_b}{\varepsilon_d}\delta \qquad (3)$$

où l'indice FF correspond à une situation où les bandes sont plates à l'interface, $\delta$ est l'épaisseur de la couche isolante et $\varepsilon_d$ sa constante diélectrique. Si l'on veut au moins inverser la courbure de bandes, il conviendra alors d'appliquer une différence de potentiel $(V_m - V_{pk}) \leq -\Delta V_{th}$ avec:

$$\Delta V_{th} \simeq \frac{4\delta\sqrt{\varepsilon_s \Delta U_{bb} e N_a}}{\varepsilon_d} \qquad (4)$$

L'homme du métier comprendra toutefois qu'une amélioration du rendement quantique sera obtenue dès lors que $V_m < V_{pk}$, dans la mesure où toute réduction de la courbure de bandes, avant même son inversion, réduira la largeur de la cuvette de potentiel à l'interface et diminuera par conséquent la probabilité de recombinaison des photoélectrons.

## Revendications

1. Détecteur de rayonnement électromagnétique comprenant :

   - une fenêtre d'entrée en verre (310) possédant une face amont (311) destinée à recevoir un flux de photons incidents ainsi qu'une face aval (312) opposée à la face amont,
   - une photocathode sous la forme d'une couche semiconductrice (320), destinée à générer des photoélectrons à partir des photons incidents et à émettre lesdits photoélectrons ainsi générés,
   - un dispositif multiplicateur d'électrons (330) configuré pour recevoir les photoélectrons émis par la photocathode et à générer pour chaque photoélectron reçu une pluralité d'électrons secondaires et
   - un dispositif de sortie (340) configuré pour générer un signal de sortie à partir desdits électrons secondaires,
   - une couche conductrice transparente (316) étant déposée sur la face aval (312) de la fenêtre d'entrée, et
   - une couche mince isolante (317) étant disposée entre ladite couche conductrice (316) et la couche semiconductrice (320),

   la couche conductrice (316) étant reliée électriquement à une première électrode (315) et la couche semiconductrice (320) étant reliée électriquement à une seconde électrode (325), la première électrode étant destinée à être portée à un potentiel inférieur à celui appliqué à la second électrode ;
   **caractérisé en ce que** la différence de potentiel appliquée entre la seconde électrode (325) et la première

   $$\frac{4\delta\sqrt{\varepsilon_s \Delta U_{bb} e N_a}}{\varepsilon_d}$$

   électrode (315) est choisie supérieure ou égale à $\qquad$ où $\varepsilon_s$ et $\varepsilon_d$ sont respectivement les constantes diélectriques de la couche semiconductrice (320) et de la couche mince isolante (317), $\delta$ est l'épaisseur de la couche isolante, $\Delta U_{bb}$ est l'amplitude de la courbure de bande en absence de différence de potentiel appliquée, $N_a$ est la concentration d'accepteurs dans la couche semiconductrice (320) et $e$ est la charge de l'électron.

2. Détecteur de rayonnement électromagnétique selon la revendication 1, **caractérisé en ce que** la couche semiconductrice est réalisée dans un matériau semiconducteur polycristallin.

3. Détecteur de rayonnement électromagnétique selon la revendication 2, **caractérisé en ce que** le matériau semiconducteur polycristallin est choisi parmi $SbK_2Cs$, $SbRb_2Cs$, $SbRb_2Cs$, $SbCs_3$, $SbNa_3$, $SbNaKRbCs$, $SbNaKCs$, $SbNa_2KCs$.

4. Détecteur de rayonnement électromagnétique selon la revendication 1, **caractérisé en ce que** la couche semiconductrice est réalisée dans un matériau semiconducteur monocristallin III-IV ou II-VI.

5. Détecteur de rayonnement électromagnétique selon l'une des revendications précédentes, **caractérisé en ce que** la couche conductrice transparente est réalisée en ITO ou ZnO.

6. Détecteur de rayonnement électromagnétique selon l'une des revendications précédentes, **caractérisé en ce que** la couche mince isolante est réalisée dans un matériau diélectrique présentant une tension de claquage supérieure à 1 V/ 10 nm.

7. Détecteur de rayonnement électromagnétique, selon la revendication 6, **caractérisé en ce que** la couche mince isolante a une épaisseur de 100 à 200 nm.

8. Détecteur de rayonnement électromagnétique selon l'une des revendications précédentes, **caractérisé en ce que** le matériau diélectrique est choisi parmi $Al_2O_3$ , $SiO_2$, $HfO_3$.

## Patentansprüche

1. Detektor für elektromagnetische Strahlung, der Folgendes umfasst:

   - Ein Glaseintrittsfenster (310) mit einer stromaufwärts gelegenen Seite (311), die dazu bestimmt ist, einen einfallenden Photonenstrom aufzunehmen, und einer stromabwärts gelegenen Seite (312), die der stromaufwärts gelegenen Seite gegenüberliegt,
   - eine Fotokathode in Form einer Halbleiterschicht (320), die Photoelektronen aus den einfallenden Photonen erzeugt, und die erzeugten Photoelektronen emittiert,
   - eine Elektronenvervielfachungsvorrichtung (330), die so konfiguriert ist, dass sie die von der Fotokathode emittierten Photoelektronen aufnimmt und für jedes aufgenommene Photoelektron eine Vielzahl von Sekundärelektronen erzeugt, und
   - ein Ausgabegerät (340), das so konfiguriert ist, dass es aus den Sekundärelektronen ein Ausgabesignal erzeugt,
   - eine transparente leitfähige Schicht (316), die auf der stromabwärtigen Seite (312) des Eintrittsfensters aufgebracht ist, und
   - ein isolierender Dünnfilm (317), der zwischen der leitenden Schicht (316) und der Halbleiterschicht (320) angeordnet ist,
   wobei die leitende Schicht (316) elektrisch mit einer ersten Elektrode (315) verbunden ist und die Halbleiterschicht (320) elektrisch mit einer zweiten Elektrode (325) verbunden ist, die erste Elektrode dazu bestimmt ist, auf ein Potential gebracht zu werden, das unter dem Potential liegt, das an die zweite Elektrode angelegt wird;
   **dadurch gekennzeichnet, dass** die Potentialdifferenz, die zwischen der zweiten Elektrode (325) und der ersten Elektrode (315) angelegt ist, einen Wert hat, der aus größer oder gleich

   $$\frac{4\delta\sqrt{\varepsilon_s \Delta U_{bb} e N_a}}{\varepsilon_d}$$

   gewählt wird, wobei $\varepsilon_s$ und $\varepsilon_d$ die dielektrischen Konstanten der Halbleiterschicht (320) bzw. des isolierenden Dünnfilms (317) sind, $\delta$ die Dicke des Isolierfilms, $\Delta U_{bb}$ die Amplitude der Bandkrümmung in Abwesenheit einer angelegten Potentialdifferenz, $Na$ die Akzeptor-Konzentration in der Halbleiterschicht (320) und $e$ die Ladung des Elektrons.

2. Detektor für elektromagnetische Strahlung nach Anspruch 1, **dadurch gekennzeichnet, dass** die Halbleiterschicht aus einem polykristallinen Halbleitermaterial hergestellt ist.

3. Detektor für elektromagnetische Strahlung nach Anspruch 2, **dadurch gekennzeichnet, dass** das polykristalline Halbleitermaterial aus $SbK_2Cs$, $SbRb_2Cs$, $SbRb_2Cs$, $SbCs_3$, $SbNa_3$, SbNaKRbCs, SbNaKCs, $SbNa_2KCs$ ausgewählt ist.

4. Detektor für elektromagnetische Strahlung nach Anspruch 1, **dadurch gekennzeichnet, dass** die Halbleiterschicht aus einem monokristallinen Halbleitermaterial der Gruppe III-IV oder II-VI hergestellt ist.

5. Detektor für elektromagnetische Strahlung nach einem der vorhergehenden Ansprüche, **dadurch gekennzeichnet, dass** der transparente leitende Dünnfilm aus ITO oder ZnO hergestellt ist.

6. Detektor für elektromagnetische Strahlung nach einem der vorhergehenden Ansprüche, **dadurch gekennzeichnet, dass** der isolierende Dünnfilm aus einem dielektrischen Material mit einer Durchbruchsspannung von mehr als 1 V/10 nm besteht.

7. Detektor für elektromagnetische Strahlung nach Anspruch 6, **dadurch gekennzeichnet, dass** der isolierende Dünnfilm eine Dicke von 100 bis 200 nm aufweist.

8. Detektor für elektromagnetische Strahlung nach einem der vorhergehenden Ansprüche, der **dadurch gekennzeichnet ist, dass** das dielektrische Material aus $Al_2O_3$, $SiO_2$, $HfO_3$ ausgewählt ist.

**Claims**

1. An electromagnetic radiation detector comprising:

    • a glass inlet window (310) having an upstream face (311) intended to receive a flux of incident photons as well as a downstream face (312) opposite to the upstream face,
    • a photocathode in the form of a semiconductor layer (320), intended to generate photoelectrons from the incident photons and to emit said photoelectrons thus generated,
    • an electron multiplier device (330) configured to receive the photoelectrons emitted by the photocathode and to generate for each received photoelectron a plurality of secondary electrons,
    • an output device (340) configured to generate an output signal from said secondary electrons,
    • a transparent conductive layer (316) deposited over the downstream face (312) of the inlet window, and
    • a thin insulating layer (317) disposed between said conductive layer (316) and the semiconductor layer (320),

the conductive layer being electrically connected to a first electrode (315) and the semiconductor layer (320) being electrically connected to a second electrode (325), the first electrode being intended to be set at a potential lower than that applied at the second electrode, **characterized in that** the potential difference applied between the second electrode (325) and the first electrode (315) is selected higher than or equal to $\dfrac{4\delta\sqrt{\varepsilon_s \Delta U_{bb} e N_a}}{\varepsilon_d}$ where $\varepsilon_s$ and $\varepsilon_d$ are respectively the dielectric constants of the semiconductor layer (320) and of the thin insulating layer (317), $\delta$ is the thickness of the insulating layer, $\Delta U_{bb}$ is the amplitude of the band bending in the absence of any applied potential difference, $N_a$ is the concentration of acceptors in the semiconductor layer (320) and e is the charge of the electron.

2. The electromagnetic radiation detector according to claim 1, **characterised in that** the semiconductor layer is made of a polycrystalline semiconductor material.

3. The electromagnetic radiation detector according to claim 2, **characterised in that** the polycrystalline semiconductor material is selected from $SbK_2Cs$, $SbRb_2Cs$, $SbRb_2Cs$, $SbCs_3$, $SbNa_3$, $SbNaKRbCs$, $SbNaKCs$, $SbNa_2KCs$.

4. The electromagnetic radiation detector according to claim 1, **characterised in that** the semiconductor layer is made of a III-IV or II-VI monocrystalline semiconductor material.

5. The electromagnetic radiation detector according to one of the preceding claims, **characterised in that** the transparent conductive layer is made of ITO or ZnO.

6. The electromagnetic radiation detector according to one of the preceding claims, **characterised in that** the thin insulating layer is made of a dielectric material having a breakdown voltage higher than 1 V/ 10 nm.

7. The electromagnetic radiation detector according to claim 6, **characterised in that** the thin insulating layer has a thickness of 100 to 200 nm.

8. The electromagnetic radiation detector according to one of the preceding claims, **characterised in that** the dielectric material is selected from $Al_2O_3$, $SiO_2$, $HfO_3$.

photons incidents

111
112

e primaires

121
122

e secondaires

110

120

130

140

## FIG.1

FIG.2

FIG.3

FIG.4

## RÉFÉRENCES CITÉES DANS LA DESCRIPTION

**Documents brevets cités dans la description**

- US 20140239157 A1
- FR 2961628 A
- FR 2925218 A